Europäisches Patentamt

(19) European Patent Office   (11) Publication number: **0 124 315**

Office européen des brevets   **B1**

(12)   **EUROPEAN PATENT SPECIFICATION**

(45) Date of publication of patent specification: **10.08.88**   (51) Int. Cl.⁴: **H 03 F 3/30**

(21) Application number: **84302599.0**

(22) Date of filing: **17.04.84**

(54) **Amplifiers.** ·

(30) Priority: **22.04.83 GB 8311072**

(43) Date of publication of application:
**07.11.84 Bulletin 84/45**

(45) Publication of the grant of the patent:
**10.08.88 Bulletin 88/32**

(84) Designated Contracting States:
**BE DE FR GB IT NL SE**

(56) References cited:
**WO-A-81/00179**
**GB-A-2 068 190**
**US-A-3 437 946**
**US-A-3 723 896**
**US-A-3 997 849**

**PATENTS ABSTRACTS OF JAPAN, vol. 2, no.
19, 8th February 1978, page 11221 E 77; & JP -
A - 52 137 957 (SANYO DENKI K.K.) 17-11-1977
AUDIO, vol. 64, no. 3, March 1980, pages 72-73,
Philadelphia, US; "Sansui model BA-F1 stereo
power amplifier"**

(73) Proprietor: **Shaye Communications Limited
Capital House 48-52 Andover Road
Winchester, Hampshire SO23 7BH (GB)**

(72) Inventor: **Pye, Michael R.
Redwood House Milnthorpe Lane
Winchester Hants S022 4NP (GB)**

(74) Representative: **Boydell, John Christopher et al
Stevens, Hewlett & Perkins 5 Quality Court
Chancery Lane
London, WC2A 1HZ (GB)**

Courier Press, Leamington Spa, England.

## Description

This invention relates to amplifiers, and particularly push-pull amplifiers arranged to operate in Class B at low supply voltages.

With the desire in the electronics industry for the miniaturisation of components and devices, and the public desire for miniature, but efficient communications devices, an amplifier capable of driving loads such as loudspeakers at low voltages is clearly of interest. We have devised such amplifiers, which are suitable for use with supply voltages of 1 to 2 volts (typically available from electronic watch batteries) and which use a minimal number of components. The circuit is designed for Class B push-pull operation and therefore is especially suited for use in the output amplifier stage of a miniature radio receiver, or low power hearing aids.

According to the invention we provide a complementary push-pull amplifier comprising a series connection between positive and negative power supply rails of first, second and third resistors, a first pnp transistor and a first npn transistor said first resistor being connected between the positive supply rail and the emitter of the first pnp transistor, said second resistor being connected between the collector of the first pnp transistor and the collector of the first npn transistor and said third resistor being connected between the emitter of said first npn transistor and the negative supply rail, and wherein the bases of the two first transistors are connected together to receive an input signal for amplification; a second pnp transistor connected in series with a second npn transistor between the power supply rails, the emitter of the second pnp transistor being connected to the positive supply rail and the emitter of the second npn transistor being connected to the negative supply rail, the collectors of the two second transistors being connected together and providing an output connection for said amplifier, and wherein the base of the second pnp transistor is connected to receive signals from the collector of the first pnp transistor and the base of the second npn transistor is connected to receive signals from the collector of the first npn transistor.

Preferred features of the invention will now be described with reference to the accompanying drawings, in which:

Figure 1 is a circuit diagram of a preferred amplifier according to the invention;

Figure 2 is a circuit diagram showing a preferred configuration for the amplifier of Figure 1; and

Figures 3 and 4 are similar to Figures 1 and 2, but show an integrated circuit implementation of the invention.

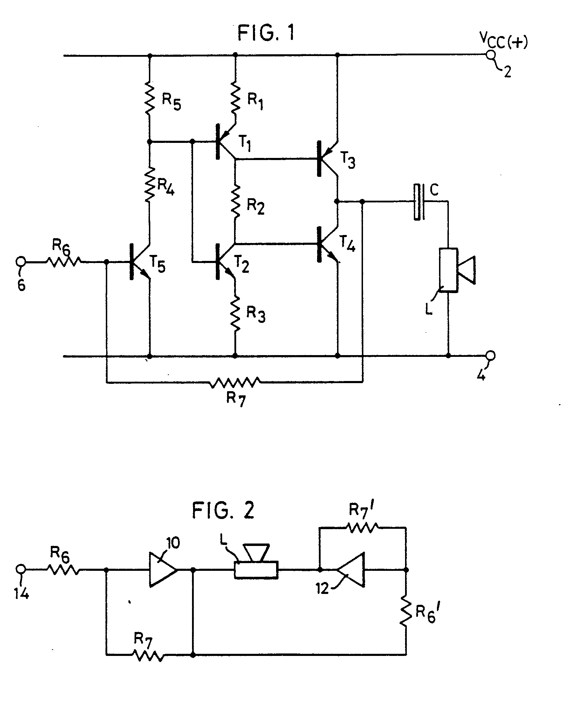

Referring to Figure 1, first, second and third resistors $R_1$, $R_2$ and $R_3$ are connected in series between the power supply rails 2 and 4 and interconnected by complementary transistors $T_1$ and $T_2$. A complementary pair of output transistors $T_3$ and $T_4$ have their bases connected to opposite ends of $R_3$. The bases of $T_1$ and $T_2$ are connected together and receive the signal from an input transistor $T_5$. The collector of $T_5$ is biassed through resistors $R_4$ and $R_5$, whereas the input to the amplifier, at 6, is through resistor $R_6$ to the base of $T_5$. A feedback from the junction of $T_3$ and $T_4$ is provided through resistor $R_7$ to the base of $T_5$. The amplified output for the circuit is also taken from the junction of $T_3$ and $T_4$, through capacitor C and loudspeaker L.

The circuit is operated with a supply voltage of about 1 to 2 volts and in the Class B mode with silicon bipolar transistors. It has a stable output bias at low voltage. The output quiescent current is adjustable, if required, by trimming the value of $R_2$. Preferably $R_1$ and $R_3$ have substantially the same value and $R_2$ a value substantially twice this. The resistor $R_4$ is included to prevent the circuit latching-up when $T_1$ goes into saturation. The amplifier is particularly useful for low voltage communication equipment, such as miniature radio receivers or hearing aids driven from small low voltage batteries.

Typical values of the components are:

$R_1 = R_3 = 120$ ohms
$R_2 = 240$ ohms
$R_5 = 10K$ ohms
$R_4 = 1K$ ohms
$R_6 = 10K$ ohms
$R_7 = 200K$ ohms
$C = 22$ microfarads

The nominal loudspeaker impedance is typically 16 ohms.

The embodiment described was designed to operate with discrete silicon bipolar transistors and with a 1—2 volt supply. The invention also applies however to the use of germanium transistors, whereby a supply voltage of about 0.6 to 1.2 volts may be employed. The invention is applicable to circuits in integrated form as well as to discrete component circuits.

The circuit enables the output transistors $T_3$ and $T_4$ to have a stable and predictable bias current when quiescent. Also, the bias and drive arrangement provided by $T_1$ and $T_2$ with $R_1$, $R_2$ and $R_3$ permits the output voltage at the collectors of $T_3$ and $T_4$ to swing the entire supply voltage less the saturation voltages of $T_3$ and $T_4$. This is of especial advantage since normal complementary Class B push-pull amplifiers using silicon transistors do not permit operation at about 1 volt and allow large output voltage swings.

In a preferred mode of operation, the circuit is employed in a bridge configuration as shown in Figure 2. Referring to the latter a pair of amplifier circuits as just described with reference to Figure 1 are illustrated generally at 10 and 12 and with their corresponding input resistors $R_6$ and $R_6'$, respectively, and feedback resistors $R_7$ and $R_7'$ respectively. Signal input is applied to $R_6$ at 14 and the output of the first amplifier 10 employed to drive the second amplifier 12 through $R_6'$. The gain of the second amplifier is set to unity and therefore, typically:

$$R_6' = R_7'$$
$$R_7 = 50\ R_6$$

The bridge configuration is particularly useful for obtaining increased output powers at low voltage without the use of low impedance loads and large value low dissipation factor output capacitors. The elimination of the output capacitor gives both a cost and size factor saving.

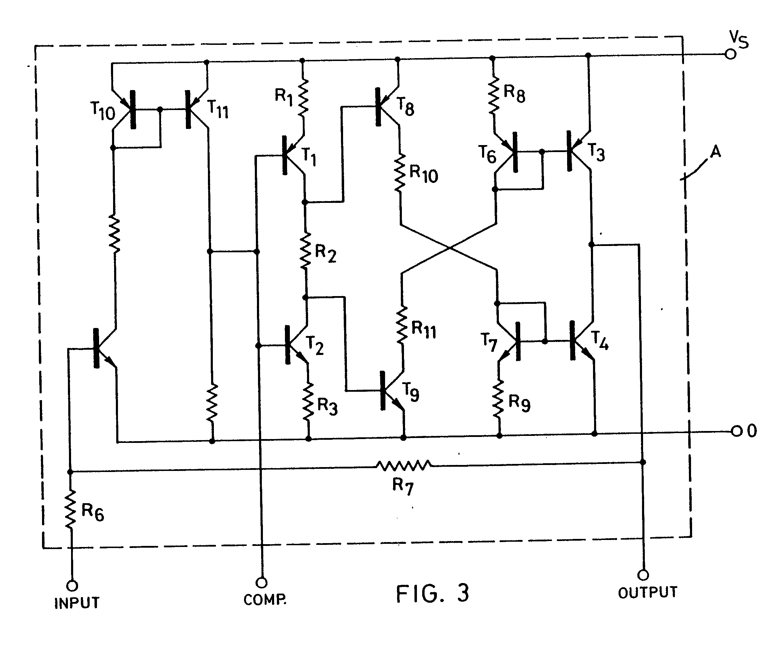

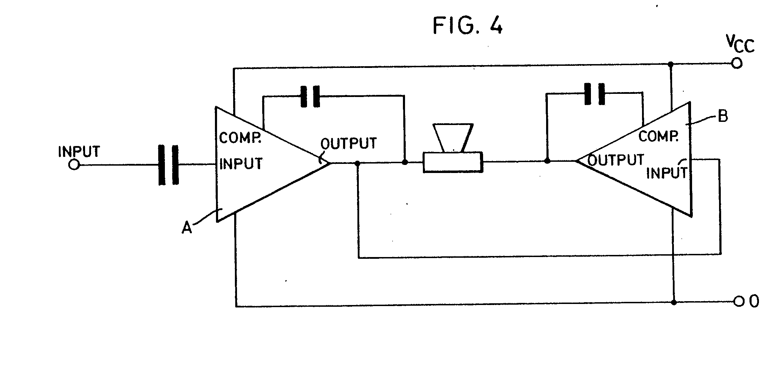

A silicon integrated circuit implementation of the invention as shown in Figures 3 and 4. Referring to Figure 3, transistors and resistors having the same functions (but not necessarily the same values) as the Figures 1 and 2 embodiment are similarly numbered. Thus, the biassing chain $R_1$, $T_1$, $R_2$, $T_2$, $R_3$ supplies push-pull output transistors $T_3$ and $T_4$. The latter are in the form of current mirrors with $T_6$ and $T_7$, respectively, to provide a defined current gain. A preferred mirror ratio $T_6:T_3$; $T_7:T_4$ is about 10:1. An additional drive stage $T_8$, $T_9$ is employed to provide adequate overall current gain. The use of current mirrors plus an additional drive stage compensates for the somewhat inferior current gain performance of integrated pnp devices, particularly at high currents.

The resistors $R_8$, $R_9$ allow effective gain boost at high drive levels whereas resistors $R_{10}$, $R_{11}$ limit the drive current available to the current mirrors.

Because of the additional driver stage a phase reversal occurs which is recovered on feedback by the use of an additional phase inverter in the form of a further current mirror $T_{10}$, $T_{11}$ typically with a ratio of about 1:5.

The amplifier A, within the dashed lines as shown may be used as a single-ended integrated amplifier with suitable A.C. coupling components to its input, A.C. compensation ("comp"), and output connections. Preferably however it is employed in a manner similar to that shown in Figure 2—as a bridge amplifier in conjunction with a second, similar amplifier B, operated at unity gain and driven from the output of amplifier A. Such an arrangement is illustrated in Figure 4. Both amplifiers A and B may be disposed on a single integrated circuit.

## Claims

1. A complementary push-pull amplifier comprising a series connection between positive and negative power supply rails (2, 4) of first, second and third resistors ($R_1$, $R_2$, $R_3$) a first pnp transitor ($T_1$), and a first npn transistor ($T_2$), said first resistor being connected between the positive supply rail and the emitter of the first pnp transistor, said second resistor being connected between the collector of the first pnp transistor and the collector of the first npn transistor and said third resistor being connected between the emitter of said first npn transistor and the negative supply rail, and wherein the bases of the two first transistors are connected together to receive an input signal for amplification; a second pnp transistor ($T_3$) connected in series with a second npn transistor ($T_4$) between the power supply rails, the emitter of the second pnp transistor being connected to the positive supply rail and the emitter of the second npn transistor being connected to the negative supply rail, the collectors of the two second transistors being connected together and providing an output connection for said amplifier, and wherein the base of the second pnp transistor is connected to receive signals from the collector of the first pnp transistor and the base of the second npn transistor is connected to receive signals from the collector of the first npn transistor.

2. An amplifier according to claim 1 wherein the second resistor ($R_2$) is substantially twice the value of the first resistor ($R_1$) which is substantially the value of the third resistor ($R_3$).

3. An amplifier according to claim 1 or 2 wherein a feedback ($R_7$) is provided from the collector junction of said second transistors to a position in the signal path more adjacent the input of the amplifier.

4. An amplifier according to any of claims 1 to 3 comprising means to enable an input signal for amplification to be supplied to the base of a further transistor, the output from which is supplied to the said base connection of said first transistors.

5. An amplifier according to any of claims 1 to 4 wherein each of said second transistors forms a part of a respective current mirror.

6. An amplifier according to claim 5 which comprises a driver transistor stage ($T_8$, $T_9$) interposed between said second resistor and said current mirrors.

7. A pair of amplifiers as claimed in any of claims 1 to 6 when arranged in relation to a common load in a bridge configuration, one amplifier being arranged to receive the signal for amplification and to provide the signal to drive the second amplifier, one of said amplifiers being of substantially unity gain.

8. A circuit as claimed in any of claims 1 to 7, in combination with a loudspeaker load arranged to receive the amplified output.

**Patentansprüche**

1. Komplementärer Gegentaktverstärker mit einer Reihenschaltung aus ersten, zweiten und dritten Widerständen ($R_1$, $R_2$, $R_3$), einem ersten pnp-Transistor ($T_1$) und einem ersten npn-Transistor ($T_2$) zwischen positiver und negativer Stromversorgungsschiene (2, 4), wobei der erste Widerstand zwischen die positive Stromversorgungsschiene und den Emitter des ersten pnp-Transistors geschaltet ist, wobei der zweite Widerstand zwischen den Kollektor des ersten pnp-Transistors und den Kollektor des ersten npn-Transistors geschaltet ist, und wobei der dritte Widerstand zwischen den Emitter des ersten npn-Transistors und die negative Stromversorgungsschiene geschaltet ist, und in der die Basen der beiden ersten Transistoren miteinander verbunden sind, um ein Eingangssignal zur Verstärkung zu empfangen; mit einem zweiten pnp-Transistor (T$_3$), der in Reihe mit einem zweiten npn-Transistor (T$_4$) zwischen die Stromversorgungsschienen geschaltet ist, wobei der Emitter des zweiten pnp-Transistors mit der positiven Stromversorgungsschiene verbunden ist und der Emitter des zweiten npn-Transistors mit der negativen Stromversorgungsschiene verbunden ist, wobei die Kollektoren der zwei zweiten Transistoren miteinander verbunden sind und einen Ausgangsanschluß des Verstärkers bilden und wobei die Basis des zweiten pnp-Transistors verschaltet ist, um Signale von dem Kollektor des ersten pnp-Transistors zu empfangen und die Basis des zweiten npn-Transistors verschaltet ist, um Signale vom Kollektor des ersten npn-Transistors zu empfangen.

2. Verstärker nach Anspruch 1, bei dem der zweite Widerstand (R$_2$) im wesentlichen zweimal den Wert des ersten Widerstands (R$_1$) besitzt, der im wesentlichen den Wert des dritten Widerstands (R$_3$) aufweist.

3. Verstärker nach Anspruch 1 oder 2, bei dem eine Rückführung (R$_7$) von der Kollektorverbindung der zweiten Transistoren zu einer Stelle im Signalpfad mehr in der Nähe des Eingangs des Verstärkers vorgesehen ist.

4. Verstärker nach einem der Ansprüche 1 bis 3 mit einer Vorrichtung, die ermöglicht, daß ein Eingangssignal zur Verstärkung zur Basis eines weiteren Transistors zugeführt wird, dessen Ausgang zu der Basen-Verbindung der ersten Transistoren geführt wird.

5. Verstärker nach einem der Ansprüche 1 bis 4, bei dem jeder der zweiten Transistoren jeweils einen Teil eines Stromspiegels bilden.

6. Verstärker nach Anspruch 5 mit einer Treibertransistorstufe (T$_8$, T$_9$), die zwischen dem zweiten Widerstand und den Stromspiegeln eingefügt ist.

7. Verstärkerpaar aus Verstärkern nach einem der Ansprüche 1 bis 6, die in Bezug auf eine gemeinsame Last in einer Brückenanordnung angeordnet sind, wobei ein Verstärker dafür vorgesehen ist, das Signal zur Verstärkung zu empfangen und das Signal, das den zweiten Verstärker antreibt, bereitzustellen und wobei einer der Verstärker im wesentlichen den Verstärkungsfaktor Eins aufweist.

8. Schaltkreis nach einem der Ansprüche 1 bis 7 in Kombination mit einer Lautsprecherlast, angeordnet um das verstärkte Ausgangssignal zu empfangen.

**Revendications**

1. Un amplificateur push-pull complémentaire comportant: reliés en série entre des lignes d'alimentation positive et négative (2, 4), une première, une seconde et une troisième résistances (R1, R2, R3), un premier transistor PNP (T1) et un premier transistor NPN (T2), la première résistance étant montée entre la ligne d'alimentation positive et l'émetteur du premier transistor PNP, la seconde, résistance étant montée entre le collecteur du premier transistor PNP et le collecteur du premier transistor NPN et la troisième résistance étant montée entre l'émetteur du premier transistor NPN et la ligne d'alimentation négative, et dans lequel les bases des deux premiers transistors sont reliées ensemble et reçoivent un signal d'entrée à amplifier; un second transistor PNP (T3) relié en série à un second transistor NPN (T4) entre les lignes d'alimentation, l'émetteur du second transistor PNP étant relié à la ligne d'alimentation positive et l'émetteur du second transistor NPN étant relié à la ligne d'alimentation négative, les collecteurs des deux seconds transistors étant reliés ensemble et formant une borne de sortie de l'amplificateur, et dans lequel la base du second transistor PNP est reliée de manière à recevoir des signaux du collecteur du premier transistor PNP, et la base du second transistor NPN est relié de manière à recevoir des signaux du collecteur du premier transistor NPN.

2. L'amplificateur de la revendication 1, dans lequel la seconde résistance (R2) a une valeur pratiquement double de celle de la première résistance (R1), qui a une valeur pratiquement la même que celle de la troisième résistance (R3).

3. L'amplificateur de l'une des revendications 1 ou 2, dans lequel on prévoit une rétroaction (R7) allant de la jonction de collecteurs desdits seconds transistors vers un point du trajet du signal plus proche de l'entrée de l'amplificateur.

4. L'amplificateur de l'une des revendications 1 à 3, comprenant des moyens pour activer un signal d'entrée à amplifier de manière à l'appliquer à la base d'un autre transistor, dont le signal de sortie est appliqué à ladite connexion de base desdits premiers transistors.

5. L'amplificateur de l'une des revendications 1 à 4, dans lequel chacun desdits seconds transistors fait partie d'un miroir de courant respectif.

6. L'amplificateur de la revendication 5, comprenant un étage de pilotage de transistor (T8, T9) intercalé entre la seconde résistance et lesdits miroirs de courant.

7. Une paire d'amplificateurs selon l'une des revendications 1 à 6, disposés par rapport à une charge commune dans une configuration en pont, l'un des amplificateurs étant conçu pour recevoir le signal à amplifier et pour délivrer le signal de pilotage du second amplificateur, l'un des amplificateurs étant de gain pratiquement égal à l'unité.

8. Le circuit de l'une des revendications 1 à 7, combiné à un haut-parleur de charge disposé de manière à recevoir le signal de sortie amplifié.

## FIG. 1

## FIG. 2

FIG. 3

FIG. 4